# EUROPÄISCHE PATENTSCHRIFT

(11) **EP 2 529 423 B1**
(45) Veröffentlichungstag und Bekanntmachung des Hinweises auf die Patenterteilung: **12.10.2016**
(21) Anmeldenummer: 11701989.3
(22) Anmeldetag: 26.01.2011
(51) Int. Cl.: H01L 41/083

(54) **PIEZOELEKTRISCHES BAUELEMENT**
PIEZO ELECTRICAL COMPONENT
COMPOSANT PIÉZOÉLECTRIQUE

(30) Priorität: 27.01.2010 DE 102010005906
(43) Veröffentlichungstag der Anmeldung: 05.12.2012
(73) Patentinhaber: Epcos AG, 81669 München (DE)
(72) Erfinder: GLAZUNOV, Alexander, 8530 Deutschlandsberg (AT); DERNOVSEK, Oliver, A-8501 Lieboch (AT)
(74) Vertreter: Epping - Hermann - Fischer
(86) Internationale Anmeldenummer: PCT/EP2011/051069
(87) Internationale Veröffentlichungsnummer: WO 2011/092205

(56) Entgegenhaltungen:
- DE-A1- 10 201 641
- DE-A1-102007 022 093
- US-A- 4 885 498
- US-A- 4 921 415
- US-A1- 2003 031 622
- US-A1- 2003 062 806

## Beschreibung

Die Erfindung betrifft ein piezoelektrisches Bauelement mit piezoelektrischen Schichten.

Vielschichtige piezoelektrische Bauelemente, wie etwa vielschichtige piezoelektrische Aktoren, umfassen mehrere Schichten eines piezoelektrischen Materials. Üblicherweise wird im ganzen Aktor das gleiche piezoelektrische Material verwendet.

Piezoelektrische Aktoren sind aus der DE 102 00 7022093 A1, der DE 102 34 787 C1 und der DE 103 07 825 A1 bekannt.

Aufgabe der Erfindung ist es ein piezoelektrisches Bauelement mit verbesserten Eigenschaften zu beschreiben.

Es wird ein piezoelektrisches Bauelement angegeben, welches einen Stapel aus übereinander angeordneten piezoelektrischen Schichten und dazwischen angeordneten Elektrodenschichten aufweist, bei dem der Stapel zumindest eine erste piezoelektrische Schicht mit einer ersten piezoelektrischen Ladungskonstanten und direkt dazu benachbart mindestens eine zweite piezoelektrische Schicht mit einer zweiten piezoelektrischen Ladungskonstanten aufweist. Die piezoelektrische Ladungskonstante beschreibt eine Ausdehnung der piezoelektrischen Schicht senkrecht zu einem elektrischen Feld bei einer an die Elektrodenschichten angelegten Spannung. Die erste piezoelektrische Ladungskonstante ist verschieden von der zweiten piezoelektrischen Ladungskonstanten.

Insbesondere kann das piezoelektrische Bauelement als Piezoaktor in Vielschichtbauweise ausgebildet sein.

Die piezoelektrische Ladungskonstante dient als Maß dafür, wie stark die Dehnung der piezoelektrischen Schichten senkrecht zu einem elektrischen Feld beim Anlegen einer vorgegebenen Spannung an die Elektrodenschichten ist. Werden zwei Materialien mit unterschiedlichen piezoelektrischen Ladungskonstanten miteinander in Kontakt gebracht, kann an ihrer Kontaktgrenze ein Unterschied an mechanischen Spannungen auf Grund der unterschiedlichen Dehnung der zwei Materialien während der Polarisation auftreten. Dies kann die Bildung von Rissen an der Kontaktgrenze zwischen beiden Materialien fördern.

Diese Risse können in einem so genannten inaktiven Bereich des Aktors, in dem sich nur jeweils der gleichen elektrischen Polarität zugeordnete Elektroden befinden, beispielsweise an der Grenze der zwei piezoelektrischer Schichten und damit in der Ebene einer Elektrodenschicht verlaufen. Für den Fall dass die Risse beim Übergang in einen so genannten aktiven Bereich des Aktors, in dem Elektroden mit entgegengesetzter Polarität abwechselnd übereinander angeordnet sind, unkontrolliert abknicken, können sie zwei oder mehr Elektrodenschichten überbrücken. In diesem Fall können Kurzschlüsse entstehen, was zum Versagen des piezoelektrischen Aktors führen kann. Die Zuverlässigkeit und Lebensdauer eines vielschichtigen piezoelektrischen Aktors hängt folglich entscheidend von der Beherrschung eventuell auftretender Risse ab. Ein Abknicken der auftretenden Risse kann durch die unterschiedlichen piezoelektrischen Ladungskonstanten der ersten und der zweiten Schicht verhindert werden.

Für das hier beschriebene piezoelektrische Bauelement ist die erste und zweite piezoelektrische Schicht vorzugsweise jeweils derart gewählt, dass eine Kontaktgrenze zwischen den beiden Schichten ausgebildet ist, wobei der Unterschied der piezoelektrischen Ladungskonstanten der ersten piezoelektrische Schicht und der zweiten piezoelektrischen Schicht groß genug ist, dass bei Anlegung einer Spannung an die Elektrodenschichten Risse hervorgerufen werden, welche vorzugsweise im Bereich der Kontaktgrenze liegen und welche im Wesentlichen parallel zu den Elektrodenschichten verlaufen.

Das beschriebene piezoelektrische Bauelement hat folglich den Vorteil, dass der Bereich, in dem die Risse entstehen, vorgegeben werden kann. Zudem kann der Verlauf der auftretenden Risse vorgegeben werden. Insbesondere können die im piezoelektrischen Material auftretenden mechanischen Spannungen durch den Einsatz der piezoelektrischen Schichten mit unterschiedlichen piezoelektrischen Ladungskonstanten derart abgebaut werden, dass kontrolliert und insbesondere parallel zu den Elektrodenschichten verlaufende Risse erzeugt werden sowie unkontrolliert abknickende Risse vermieden werden können. Eine Überbrückung von zwei oder mehr Elektrodenschichten durch unkontrolliert auftretende und verlaufende Risse kann somit vermieden werden.

In einer vorteilhaften Ausführung weist das piezoelektrische Bauelement keine porösen Strukturen auf.

Im Gegensatz zu Rissen im piezoelektrischen Material, die mindestens zwei Elektrodenschichten überbrücken, bewirken Risse, die parallel oder zumindest im Wesentlichen parallel zu den Innenelektroden verlaufen beinahe keine Einschränkung der Lebensdauer von Aktoren. Dabei bedeutet "im Wesentlichen parallel", dass die Risse zwar nicht zwingend vollständig geradlinig und im mathematischen Sinne parallel, aber dennoch mit einer Haupterstreckungsrichtung entlang der Elektrodenschichten verlaufen und dabei insbesondere keinen Verlauf aufweisen, durch den zwei oder mehr Elektrodenschichten überbrückt werden können.

Erfindungsgemäss ist die eine der beiden piezoelektrischen Ladungskonstanten um einen Faktor 1,2 bis 3,0 größer als die andere der beiden piezoelektrischen Ladungskonstanten.

Je größer die piezoelektrische Ladungskonstante einer piezoelektrischen Schicht ist, umso größer ist die Dehnung der jeweiligen Schicht senkrecht zu einem durch Anlegen einer Spannung an die Elektrodenschichten erzeugten elektrischen Feld mit vorgegebener Stärke. Die eine der beiden Ladungskonstanten ist um einen Faktor 1,2 bis 3,0, vorzugsweise um einen Faktor 1,3 bis 2,0, größer als die andere der beiden Ladungskonstanten. Auf Grund der dadurch auftretenden unterschiedlichen Dehnung der piezoelektrischen Schichten können gezielt lokale Spannungen erzeugt und derart wieder abgebaut werden, dass eine gezielte Bildung und ein gezielter Verlauf von Rissen an der Kontaktgrenze zwischen den piezoelektrischen Schichten erreicht wird. Die Lebensdauer des piezoelektrischen Materials kann somit entscheidend erhöht werden.

Die erste und die zweite piezoelektrische Schicht können unterschiedliche Curie-Temperaturen aufweisen, was zu unterschiedlichen piezoelektrischen Ladungskonstanten der betreffenden Schichten führen kann.

Die Curie-Temperatur dient als Maß für die Polarisierbarkeit der piezoelektrischen Schicht und somit als Maß für die Dehnbarkeit der Schicht in einem elektrischen Feld einer vorgegebenen Stärke. Die Curie-Temperatur einer piezoelektrischen Schicht steht in direktem Zusammenhang mit der piezoelektrischen Ladungskonstante der betreffenden Schicht. Insbesondere sinkt die piezoelektrische Ladungskonstante, und somit die Dehnbarkeit eines piezoelektrischen Materials, mit steigender Curie-Temperatur des piezoelektrischen Materials.

In einer bevorzugten Ausführungsform des Bauelements beträgt der Unterschied zwischen den Curie-Temperaturen der ersten piezoelektrischen Schicht und der zweiten piezoelektrischen Schicht 20°C bis 200°C.

Durch eine betreffende Wahl der Curie-Temperatur der piezoelektrischen Schichten kann somit eine unterschiedliche, Dehnung der Schichten im elektrischen Feld erreicht werden, was zur gezielten Rissbildung insbesondere an der Kontaktgrenze zwischen den piezoelektrischen Schichten sowie einem Verlauf der Risse im Wesentlichen parallel zu den Elektrodenschichten führt. Der Unterschied zwischen den Curie-Temperaturen der ersten und der zweiten piezoelektrischen Schicht kann 20°C bis 200°C betragen, vorzugsweise 20°C bis 80°C. Der Unterschied in den Curie-Temperaturen kann beispielsweise durch, vorzugsweise unterschiedliche, Dotierung der piezoelektrischen Schichten erreicht werden.

In einer bevorzugten Ausführungsform des Bauelements unterscheiden sich die erste und die zweite piezoelektrische Schicht in mindestens einer der folgenden Eigenschaften: Keramikmaterial, Dotierstoff, Dotierstoffkonzentrationen, Partikelgrößen des jeweils verwendeten Ausgangsmaterials, Schichtdicke.

Um die erste und die zweite piezoelektrische Schicht mit unterschiedlichen piezoelektrischen Ladungskonstanten herzustellen, können die Schichten sich in genau einer der vorgenannten Eigenschaften oder auch in mehreren der vorgenannten Eigenschaften unterscheiden. Dabei kann es vorteilhaft hinsichtlich der Prozessierbarkeit und der Wirtschaftlichkeit des Herstellungsprozesses sein, wenn sich die erste und die zweite piezoelektrische Schicht in genau einer oder nur wenigen der vorgenannten Eigenschaften unterschieden.

Die erste piezoelektrische Schicht kann beispielsweise ein bleihaltiges Keramikmaterial, etwa basierend auf Blei-Zirkonat-Titanat (PZT) aufweisen. Die zweite piezoelektrische Schicht kann ein bleiloses Keramikmaterial aufweisen. Alternativ dazu können die erste und die zweite piezoelektrische Schicht jeweils ein bleiloses Keramikmaterial aufweisen und sich in einer der vorgenannten Eigenschaften, beispielsweise der Dotierung des Keramikmaterials, unterscheiden.

Eine Ausführungsform des Bauelements sieht vor, dass die erste und die zweite piezoelektrische Schicht jeweils ein Keramikmaterial aufweist welches aus mehreren chemischen Elementen gebildet ist, wobei die Elemente jeweils in einer bestimmten Konzentration vorliegen. Die erste und die zweite piezoelektrische Schicht können sich in der Konzentration zumindest eines der Elemente des Keramikmaterials voneinander unterscheiden.

Für den Fall dass die erste piezoelektrische Schicht und die zweite piezoelektrische Schicht jeweils aus PZT als Keramikmaterial besteht, können sich die erste und die zweite piezoelektrische Schicht beispielsweise im Titangehalt, also der jeweiligen Konzentration des Elements Titan, voneinander unterschieden.

Eine Ausführungsform des Bauelements sieht vor, dass die erste und die zweite piezoelektrische Schicht jeweils ein Keramikmaterial aufweist welches mit den gleichen chemischen Elementen gebildet ist, wobei das Keramikmaterial in Abhängigkeit der Konzentration zumindest eines der Elemente im Keramikmaterial zwei unterschiedliche Strukturen aufweist. Die Konzentrationen des zumindest einen Elements des Keramikmaterials in der ersten und zweiten piezoelektrischen Schicht sind jeweils derart gewählt, dass die erste piezoelektrische Schicht das Keramikmaterial mit der ersten Struktur und die zweite piezoelektrische Schicht das Keramikmaterial mit der zweiten Struktur aufweist.

Mit anderen Worten, das Keramikmaterial kann eine so genannte morphotrope Phasengrenze aufweisen, welche zwischen der ersten Struktur und der zweiten Struktur des Keramikmaterials liegt. Die erste und die zweite piezoelektrische Schicht weisen demnach ein Keramikmaterial mit unterschiedlichen Konzentrationen eines Elements auf, so dass das betreffende Keramikmaterial in Abhängigkeit von der Konzentration des einen Elements einen Phasenübergang aufweist und so dass das Keramikmaterial in der ersten piezoelektrischen Schicht in einer anderen Struktur vorliegt als das Keramikmaterial in der zweiten piezoelektrischen Schicht. Dabei muss die morphotrope Phasengrenze keinen scharf definierten Phasenübergang kennzeichnen, sondern kann auch einen kontinuierlichen Übergang zwischen zwei Kristallstrukturen darstellen. Die unterschiedliche erste und zweite Struktur führt vorzugsweise zu unterschiedlichen piezoelektrischen Ladungskonstanten in der ersten und zweiten piezoelektrischen Schicht.

Beispielsweise weist PZT eine morphotrope Phasengrenze in einem Bereich von etwa 50 mol% Titan und etwa 50 mol% Zirkonat auf, wobei diese Werte von der exakten Zusammensetzung des Keramikmaterials abhängen. Mit zunehmendem Titangehalt, beginnend bei etwa 46 mol% Titan, steigt die piezoelektrische Ladungskonstante bis zum Überschreiten der morphotropen Phasengrenze an, so dass für das piezoelektrische Bauelement beispielsweise die erste piezoelektrische Schicht mit einem Titangehalt von weniger als 46 mol% und die zweite piezoelektrische Schicht mit einem Titangehalt von ca. 48 mol% gewählt werden kann.

Durch eine Auswahl eines hinsichtlich seiner Elemente gleichen Keramikmaterials für die erste und die zweite piezoelektrische Schicht, welches sich in den Konzentrationen zumindest eines Elements für die erste und zweite piezoelektrische Schicht unterscheidet, ergibt sich der Vorteil, dass eine genaue Kontrolle der Spannungen in den piezoelektrischen Schichten an der Kontaktgrenze zwischen der ersten und zweiten piezoelektrischen Schicht ermöglicht wird. Insbesondere ist eine Anpassung der ersten und zweiten piezoelektrischen Ladungskonstante durch den Unterschied der Konzentrationen des zumindest einen Elements im Keramikmaterial möglich, also im oben beschriebenen Beispiel etwa durch die Änderung des Titangehalts im Keramikmaterial.

Hier können Dotierstoffe, vorzugsweise jeweils gleiche Dotierstoffe und Dotierstoffe in gleichen Dotierstoffkonzentrationen, vorliegen. Das Verwenden von gleichen Dotierstoffen für die erste und die zweite piezoelektrische Schicht kann besondere Vorteile bei der Prozessierung des piezoelektrischen Bauelements bieten, da chemische Inhomogenitäten zwischen der ersten und der zweiten Schicht auf diese Weise gering gehalten werden können und daher keinen Einfluss auf das Sinterverhalten der betreffenden piezoelektrischen Schichten haben. Eine spezielle Anpassung des Sinterschwunds zwischen der ersten und der zweiten piezoelektrischen Schicht ist in diesem Fall unnötig.

Eine weitere Ausgestaltung sieht vor, dass die erste und die zweite piezoelektrische Schicht Keramikmaterialen aufweisen, die aus Ausgangspulvern mit unterschiedlichen Partikelgrößen hergestellt sind, wobei die Partikelgröße der Ausgangspulver größer oder gleich 0,3 µm und kleiner oder gleich 2,0 µm beträgt und wobei der Unterschied in den Partikelgrößen der Ausgangspulver größer oder gleich 0,1 µm und kleiner oder gleich 1,5 µm beträgt.

Die keramischen Schichten eines piezoelektrischen Bauelements können aus so genannten Grünfolien hergestellt werden, die neben weiteren Bestandteilen wie etwa Sinterhilfsmitteln ein Keramikpulver aufweisen. Auf die Grünfolien können Elektrodenschichten z. B. in einem Siebdruckverfahren aufgebracht werden. Die Grünfolien werden anschließend gestapelt und gemeinsam gesintert. Dabei können Keramikmaterialien, die in ihrer chemischen Zusammensetzung zwar gleich sind, sich aber in den Partikelgrößen der Ausgangspulver vor dem Sintervorgang unterscheiden, geeignet sein, um die erste und zweite piezoelektrische Schicht mit unterschiedlichen piezoelektrischen Ladungskonstanten herzustellen. Insbesondere weisen Keramikmaterialen mit gröberem Ausgangspulver nach Abschluss des Sintervorgangs üblicherweise gröbere Körner auf, was zu einer Erhöhung der piezoelektrischen Ladungskonstanten und somit zu einer größeren Dehnung des piezoelektrischen Materials senkrecht zu einem elektrischen Feld mit vorgegebener Stärke führen kann.

Für die Partikelgröße wird dabei bevorzugt ein Medianwert d50 der Verteilung der Partikelgrößen im jeweiligen Keramikmaterial angegeben. Im Folgenden wird der Medianwert d50 als Partikelgröße d50 bezeichnet. Die Partikelgröße d50 der Ausgangspulver der ersten und zweiten piezoelektrischen Schicht vor dem Sintervorgang kann größer oder gleich 0,3 µm und kleiner oder gleich 2,0 µm sein und ist bevorzugt größer oder gleich 0,4 µm und kleiner oder gleich 1,2 µm. Der Unterschied der Partikelgrößen d50 der ersten piezoelektrischen Schicht zum d50 Wert der zweiten piezoelektrischen Schicht kann größer oder gleich 0,1 µm und kleiner oder gleich 1,5 µm und bevorzugt größer oder gleich 0,3 µm und kleiner oder gleich 1,0 µm sein. Die genannten Partikelgrößen und Partikelgrößenunterschiede können besonders vorteilhaft für die Prozessierbarkeit des piezoelektrischen Bauelements bei gleichzeitiger geeigneter Wahl der ersten und zweiten piezoelektrischen Ladungskonstanten sein.

Weiterhin können sich die erste und die zweite piezoelektrische Schicht in den ihnen zugefügten Dotierstoffen unterscheiden. Insbesondere können die erste und die zweite piezoelektrische Schicht dabei das gleiche Keramikmaterial mit denselben Elementen und denselben Konzentrationen des jeweiligen Elements aufweisen, wobei dem Keramikmaterial der ersten piezoelektrischen Schicht ein anderer Dotierstoff zugesetzt ist als dem Keramikmaterial der zweiten piezoelektrischen Schicht. Dabei kann die erste piezoelektrische Schicht beispielsweise mit Neodym (Nd) dotiert sein, während die zweite piezoelektrische Schicht mit einer Mischung aus Zink (Zn) und Niobium (Nb) dotiert ist. Eine derartige Dotierstoffkombination kann insbesondere im Falle von PZT, aber auch im Falle anderer Keramikmaterialen vorteilhaft sein.

Weiterhin können die erste und die zweite piezoelektrische Schicht unterschiedliche Dotierstoffkonzentrationen aufweisen. Dabei können beide Schichten auch denselben Dotierstoff aufweisen. Für PZT als Keramikmaterial und eine Mischung aus Zn und Nb als Dotierstoffe kann beispielsweise die erste piezoelektrische Schicht eine Dotierstoffkonzentration von 2 mol% und die zweite piezoelektrische Schicht eine Dotierstoffkonzentration von 5 mol% aufweisen. Die jeweiligen Dotierstoffe und Dotierstoffkonzentrationen hängen dabei von den jeweiligen Keramikmaterialen und den bevorzugten piezoelektrischen Ladungskonstanten für die erste piezoelektrische und die zweite piezoelektrische Schicht ab.

Eine weitere Ausführungsform des Bauelements sieht vor, dass die erste piezoelektrische Schicht eine erste Schichtdicke aufweist und die zweite piezoelektrische Schicht eine zweite Schichtdicke aufweist, wobei die erste und die zweite Schichtdicke voneinander verschieden sind und wobei das Verhältnis der ersten und zweiten Schichtdicke größer oder gleich 1,1 und kleiner oder gleich 3,0 beträgt.

Durch eine Einstellung der ersten und zweiten Schichtdicke kann eine Anpassung der ersten und zweiten piezoelektrischen Ladungskonstanten in den Schichten ermöglicht werden. Der Unterschied der ersten Schichtdicke zur zweiten Schichtdicke, bezogen auf eine normale Schichtdicke kann größer oder gleich 1,1 und kleiner oder gleich 3,0 und bevorzugt größer oder gleich 1,3 und kleiner oder gleich 2,5 sein.

Gemäß zumindest einer Ausführungsform des Bauelements weist der Stapel des piezoelektrischen Bauelements eine Abfolge von direkt übereinander angeordneten Schichen auf, wobei die Abfolge gebildet ist aus einer ersten Elektrodenschicht mit einer ersten Polarität bei einer an die Elektrodenschichten angelegten Spannung, der ersten piezoelektrischen Schicht, einer zweiten Elektrodenschicht mit einer zweiten Polarität bei einer an die Elektrodenschichten angelegten Spannung, der zweiten piezoelektrischen Schicht und einer weiteren ersten Elektrodenschicht.

Zwischen jeweils einer in Stapelrichtung benachbarten ersten und zweiten Elektrodenschicht ist somit die erste piezoelektrische Schicht angeordnet, während zwischen derselben zweiten Elektrodenschicht und einer weiteren, zur zweiten Elektrodenschicht benachbarten, ersten Elektrodenschicht die zweite piezoelektrische Schicht angeordnet ist.

Gemäß zumindest einer weiteren Ausführungsform weist der Stapel des piezoelektrischen Bauelements eine Abfolge von direkt übereinander angeordneten Schichten auf, wobei die Abfolge gebildet ist aus einer ersten Elektrodenschicht mit einer ersten Polarität bei einer an die Elektrodenschichten angelegten Spannung, der ersten piezoelektrischen Schicht, der zweiten piezoelektrischen Schicht und einer zur ersten Elektrodenschicht benachbarten zweiten Elektrodenschicht mit einer zweiten Polarität bei einer an die Elektrodenschichten angelegten Spannung. Die erste und die zweite piezoelektrische Schicht befinden sich also beide zwischen einer ersten Elektrodenschicht und einer dazu benachbarten zweiten Elektrodenschicht.

Weiterhin können beide genannten Abfolgen von direkt übereinander angeordneten Schichten in einem einzigen piezoelektrischen Bauelement angeordnet sein.

Eine Ausführungsform des Bauelements sieht vor, dass die Anzahl der ersten piezoelektrischen Schichten verschieden ist von der Anzahl der zweiten piezoelektrischen Schichten.

Das piezoelektrische Bauelement kann insbesondere einen Stapel mit genau einer zweiten piezoelektrischen Schicht und einer Mehrzahl von ersten piezoelektrischen Schichten aufweisen. Alternativ dazu kann das piezoelektrische Bauelement auch eine Mehrzahl an zweiten piezoelektrischen Schichten aufweisen. Vorzugsweise sind 5%-20% aller Schichten im Stapel zweite piezoelektrische Schichten.

Eine Ausgestaltung der Erfindung sieht vor, dass der Stapel gleich viele erste und zweite piezoelektrische Schichten aufweist, so dass die Hälfte aller piezoelektrischen Schichten im Stapel erste beziehungsweise zweite piezoelektrische Schichten sind.

Im Folgenden werden zur Erläuterung der hier beschriebenen Ausführungsformen in Verbindung mit den Figuren 1 bis 10 beispielhaft piezoelektrische Bauelemente beschrieben.

Es zeigen:
- Figur 1: eine schematische Darstellung eines piezoelektrischen Aktors,
- Figuren 2A und 2B: schematische Darstellungen piezoelektrischer Aktoren,
- Figuren 3A bis 3C: schematische Darstellungen von piezoelektrischen Materialien gemäß einer Ausführungsform,
- Figur 4: eine schematische Darstellung eines piezoelektrischen Bauelements gemäß einer Ausführungsform,
- Figur 5: eine schematische Darstellung eines piezoelektrischen Bauelements gemäß einer weiteren Ausführungsform,
- Figur 6: eine schematische Darstellung eines piezoelektrischen Bauelements gemäß einer weiteren Ausführungsform,
- Figur 7: eine schematische Darstellung eines piezoelektrischen Bauelements gemäß einer weiteren Ausführungsform,
- Figur 8: einen Graphen für die Dehnung D zweier verschiedener piezoelektrischer Materialien als Funktion der elektrischen Feldstärke E,
- Figur 9: einen Graphen für die piezoelektrische Ladungskonstante d31 verschiedener piezoelektrischer Materialien als Funktion der jeweiligen Curie-Temperatur T_{C},
- Figur 10: einen Graphen für die piezoelektrische Ladungskonstante d31 als Funktion vom Titangehalt T in einem piezoelektrischen Material auf BleiZirkonat-Titanat Basis.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit bzw. zum besseren Verständnis übertrieben dick oder groß dimensioniert dargestellt sein.

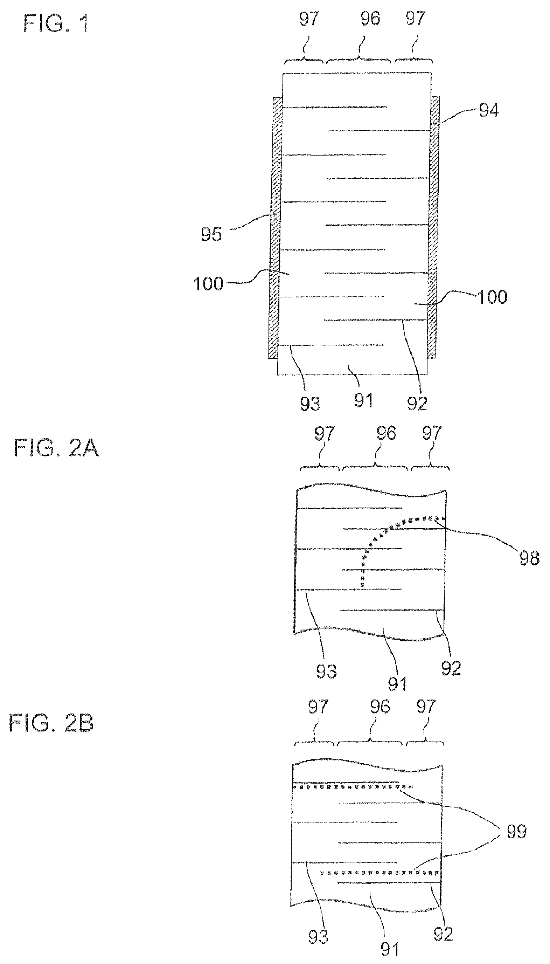

Figur 1 zeigt einen vielschichtigen piezoelektrischen Aktor, der einen Stapel 91 mit mehreren Schichten 100 eines piezoelektrischen Materials und Innenelektroden 92, 93 zwischen den piezoelektrischen Schichten 100 aufweist. Dabei wird im ganzen Aktor das gleiche piezoelektrische Material verwendet.

Um die Innenelektroden 92, 93 einfach kontaktieren zu können, ist der Aktor so ausgebildet, dass sich nur jeweils der gleichen elektrischen Polarität zugeordnete Innenelektroden 92, 93 bis zu einem Randbereich, einem so genannten inaktiven Bereich 97, des Aktors erstrecken. Die der anderen elektrischen Polarität zugeordneten Innenelektroden 93, 92 erstrecken sich an dieser Stelle nicht bis ganz zum Rand des Aktors. In einem inneren Bereich des Aktors, einem so genannten aktiven Bereich 96, sind die Innenelektroden 92, 93 mit entgegengesetzter Polarität abwechselnd übereinander angeordnet. Die Innenelektroden 92, 93 sind demnach jeweils in einer Art Kammstruktur in Form von ineinander geschobenen Kämmen ausgebildet. Über Kontaktflächen in Form von Metallisierungen 94, 95 an der Außenseite des Stapels 91 kann an die Innenelektroden 92, 93 eine elektrische Spannung angelegt werden.

Im aktiven Bereich 96 des Stapels 91, in welchem die Innenelektroden 92, 93 wechselweise übereinander angeordnet sind, wird durch das Anlegen einer elektrischen Spannung an die Innenelektroden 92, 93 ein elektrisches Feld aufgebaut.

Dadurch wird eine Dehnung des piezoelektrischen Materials des Aktors bewirkt. Im inaktiven Bereich 97 des Stapels 91 wird durch das Anlegen einer elektrischen Spannung an die Innenelektroden 92, 93 lediglich ein sehr geringes elektrisches Feld aufgebaut, so dass in diesen Bereichen das piezoelektrische Material kaum gedehnt wird. Dadurch entstehen insbesondere in den inaktiven Bereichen 97 Zugspannungen, die Risse hervorrufen können (siehe Risse 98 und 99 in den Figuren 2A und 2B).

Figuren 2A und 2B zeigen schematische Darstellungen piezoelektrischer Aktoren. Insbesondere zeigen Figuren 2A und 2B einen Teilbereich des in Figur 1 dargestellten Stapels 91.

Wie in Figur 2B gezeigt, können bei Anlegen einer elektrischen Spannung an die Innelektroden 92, 93 auf Grund der unterschiedlichen Dehnung des piezoelektrischen Materials im aktiven und inaktiven Bereich Risse 99 entstehen, die weitgehend parallel zu den Innenelektroden 92, 93 verlaufen. Im Unterschied zu dem in Figur 2A dargestellten Ausführungsbeispiel führen die weitgehend parallel zu den Innenelektroden 92, 93 verlaufenden Risse nicht zum Ausfall des Aktors.

Daneben entstehen in piezoelektrischen Aktoren aber auch Risse 98, wie in Figur 2A gezeigt, die beim Übergang vom inaktiven Bereich 97 in den aktiven Bereich 96 abknicken und dabei, wie in Figur 2A angedeutet, die Innenelektroden 92, 93 überbrücken können, so dass Kurzschlüsse entstehen. Ein derartiger Riss 98 führt zum Versagen des piezoelektrischen Aktors.

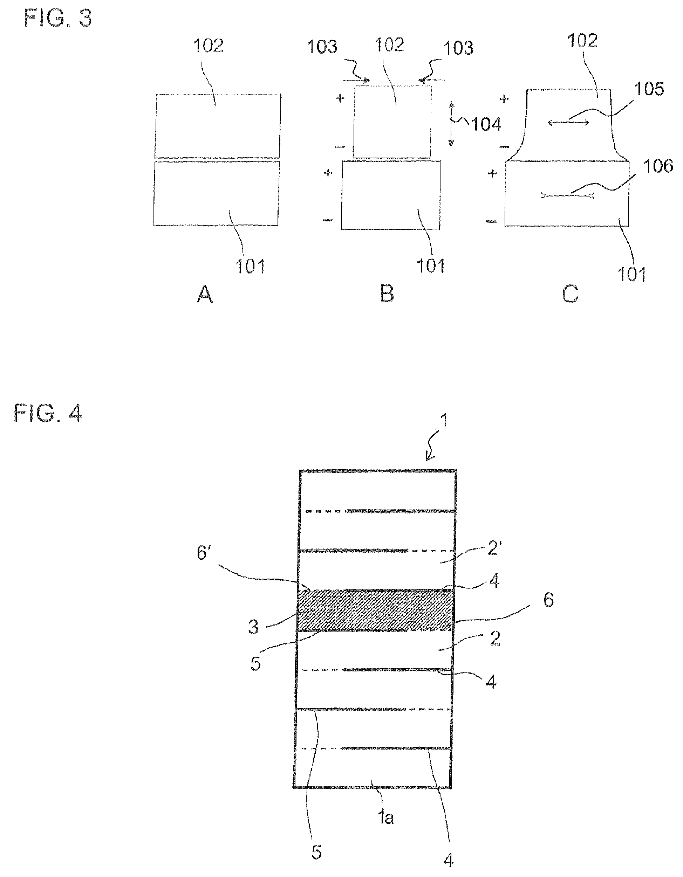

Figuren 3A bis 3C zeigen schematische Darstellungen von piezoelektrischen Materialien gemäß einer Ausführungsform. Die piezoelektrischen Materialien sind geeignet zum Einsatz in einem vielschichtigen piezoelektrischen Aktor.

Dabei weist, wie in Figur 3A dargestellt, ein erstes piezoelektrisches Material 101 eine erste piezoelektrische Ladungskonstante d31 auf. Ein zweites piezoelektrisches Material 102 weist eine zweite piezoelektrische Ladungskonstante d31 auf. Vorzugsweise ist die eine der beiden Ladungskonstanten d31 um einen Faktor 1,3 bis 2,0 größer als die andere der beiden Ladungskonstanten d31. Im gezeigten Ausführungsbeispiel ist die zweite piezoelektrische Ladungskonstante d31 größer als die erste piezoelektrische Ladungskonstante d31. Beispielsweise ist die zweite piezoelektrische Ladungskonstante d31 doppelt so groß wie die erste piezoelektrische Ladungskonstante d31. Alternativ dazu kann aber auch die erste piezoelektrische Ladungskonstante d31 einen größeren Wert haben als die zweite piezoelektrische Ladungskonstante d31.

Die piezoelektrische Ladungskonstante d31 ist dabei ein Maß für die Dehnung des piezoelektrischen Materials senkrecht zu einem elektrischen Feld bei einer an die Elektrodenschichten (hier nicht explizit dargestellt) angelegten Spannung.

Figur 3B zeigt schematisch die Verformung des ersten und zweiten piezoelektrischen Materials 101, 102 nach dem Anlegen einer elektrischen Spannung an die Elektrodenschichten bei nicht vorhandenem mechanischen Kontakt zwischen dem ersten und zweiten piezoelektrischen Material 101, 102. Das beim Anlegen der Spannung entstehende elektrische Feld ist dabei durch die Plus- und Minuszeichen angedeutet, die Elektrodenschichten sind zur Vereinfachung nicht gezeigt. Die durch das elektrische Feld hervorgerufene Verformung ist beispielhaft für das piezoelektrische Material 102 durch die Pfeile 103, 104 verdeutlicht. Pfeil 103 deutet dabei die Verformung des Materials 102 senkrecht zu den Feldlinien des elektrischen Feldes an. Pfeil 104 verdeutlicht die Verformung parallel zu den Feldlinien des elektrischen Feldes. Das zweite piezoelektrische Material 102 mit der größeren piezoelektrischen Ladungskonstante dehnt sich dabei stärker aus als das erste piezoelektrische Material 101.

Werden die piezoelektrischen Materialien 101, 102 miteinander in Kontakt gebracht und anschließend zusammen gesintert, entsteht beim Anlegen einer elektrischen Spannung an die (hier nicht dargestellten) Elektrodenschichten eine Verformung des ersten und zweiten piezoelektrischen Materials 101, 102, wie in Figur 3C dargestellt. Da das erste und zweite piezoelektrische Material 101, 102 fest miteinander verbunden sind, entstehen an der Kontaktgrenze zwischen den beiden Materialien 101, 102 mechanische Spannungen auf Grund der unterschiedlichen Dehnungen der Materialien 101, 102 im elektrischen Feld und der daraus resultierenden Druckspannung 106 im Material 101 und der Zugspannung 105 im Material 102. An der Kontaktgrenze zwischen dem ersten und dem zweiten piezoelektrischen Material 101, 102 bildet sich somit ein Gradient der Spannungen, der zur Bildung von Rissen in diesem Bereich führen soll. Die dabei entstehenden Risse verlaufen im Wesentlichen parallel zur Kontaktgrenze und, insbesondere, zu den Elektrodenschichten, so dass ein Überbrücken von zwei oder mehr Elektrodenschichten verhindert wird. Demnach werden durch die unterschiedlichen piezoelektrischen Ladungskonstanten d31 und den somit unterschiedlichen Dehnungen der Materialien 101, 102 mechanische Spannungen derart erzeugt, dass unkontrolliert abknickende Risse (siehe beispielsweise Riss 98, Figur 2A) vermieden sowie kontrolliert, insbesondere parallel zu den Elektrodenschichten, verlaufende Risse an der Kontaktgrenze zwischen dem ersten und dem zweiten piezoelektrischen Material 101, 102 gefördert werden.

Figur 4 zeigt eine schematische Darstellung eines piezoelektrischen Bauelements gemäß einer Ausführungsform.

In Figur 4 ist ein piezoelektrisches Bauelement 1 gezeigt, das als Piezoaktor in Vielschichtbauweise ausgeführt ist und das einen Stapel 1a aus übereinander angeordneten piezoelektrischen Schichten 2, 2', 3 und dazwischen angeordneten ersten und zweiten Elektrodenschichten 4, 5 aufweist. Aus Gründen der Übersichtlichkeit sind lediglich die piezoelektrischen Schichten 2, 2' und 3 sowie ein Teil der ersten Elektrodenschichten 4 und der zweiten Elektrodenschichten 5 mit Bezugszeichen versehen. Die gestrichelten Linien sind zu Verdeutlichung der piezoelektrischen Schichten eingezeichnet.

Der Stapel 1a weist wenigstens eine erste piezoelektrische Schicht 2 mit einer ersten piezoelektrischen Ladungskonstante d31 und direkt zu dieser benachbart wenigstens eine zweite piezoelektrische Schicht 3 mit einer zweiten piezoelektrischen Ladungskonstante d31 auf. Die erste und die zweite piezoelektrische Ladungskonstante d31 sind voneinander verschieden. Beispielsweise ist die zweite piezoelektrische Ladungskonstante d31 doppelt so groß wie die erste piezoelektrische Ladungskonstante d31. Alternativ dazu kann aber auch die erste piezoelektrische Ladungskonstante d31 größer sein als die zweite piezoelektrische Ladungskonstante d31. Der Übersichtlichkeit halber sind Metallisierungen an Außenseiten des Stapels 1, um die ersten und zweiten Elektrodenschichten 4, 5 zu kontaktieren und an eine elektrische Spannung anzuschließen, nicht gezeigt. Die Elektrodenschichten 4, 5 sind in diesem Ausführungsbeispiel aus Kupfer. Alternativ können die Elektrodenschichten 4, 5 beispielsweise auch eines der folgenden Materialien oder folgende Mischungen aus Materialien aufweisen: Silber, Platin, eine Legierung oder Mischung aus Kupfer und Palladium, eine Legierung oder Mischung aus Silber und Palladium, eine Mischung oder Legierung aus Platin und Silber.

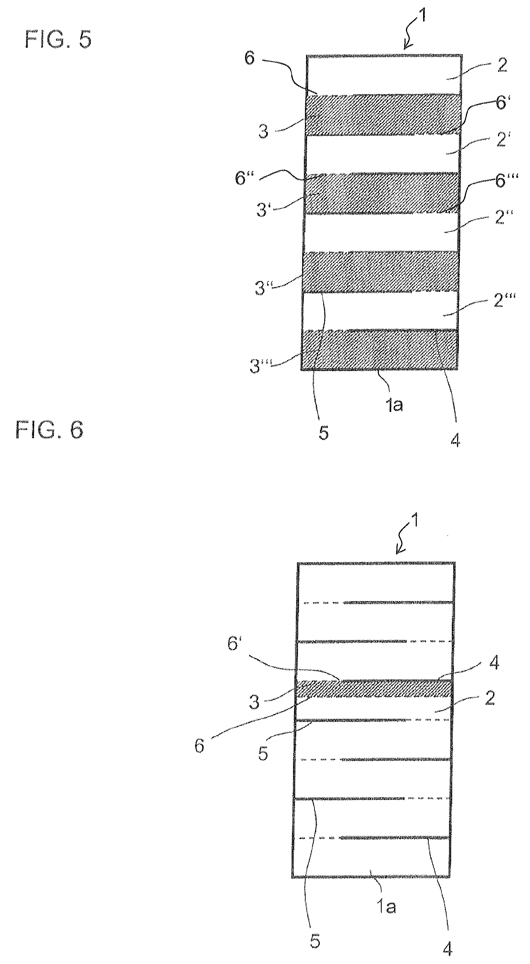

Die erste piezoelektrische Schicht 2 und die zweite piezoelektrische Schicht 3 ist jeweils zwischen zwei benachbarten Elektrodenschichten 4, 5 angeordnet, so dass der Stapel 1a in diesem Ausführungsbeispiel eine Abfolge von Schichten aufweist, die gebildet wird durch eine erste Elektrodenschicht 4 mit einer ersten Polarität bei einer an die Elektrodenschichten 4, 5 angelegten Spannung, die erste piezoelektrische Schicht 2, eine zweite Elektrodenschicht 5 mit einer zweiten Polarität bei einer an die Elektrodenschichten 4, 5 angelegten Spannung, die zweite piezoelektrische Schicht 3 und eine weitere erste Elektrodenschicht 4. Bei dem in Figur 4 gezeigten Ausführungsbeispiel ist die Anzahl der ersten piezoelektrischen Schichten 2, 2' verschieden von der Anzahl der zweiten piezoelektrischen Schichten 3. Insbesondere weist das piezoelektrische Bauelement genau eine zweite piezoelektrische Schicht 3 und eine Mehrzahl von ersten piezoelektrischen Schichten 2, 2' auf. Darüber hinaus kann das piezoelektrische Bauelement auch eine Mehrzahl an zweiten piezoelektrischen Schichten 3 aufweisen (siehe beispielsweise Figur 5).

Wie in Verbindung mit den Figuren 3A bis 3C beschrieben, unterscheiden sich die piezoelektrischen Ladungskonstanten d31 der ersten piezoelektrischen Schicht 2 und der zweiten piezoelektrische Schicht 3 derart, dass an einer Kontaktgrenze 6 zwischen der ersten piezoelektrischen Schicht 2 und der zweiten piezoelektrischen Schicht 3 bei thermischen Behandlungen, beim Metallisieren, beim Löten, beim Polungsprozess oder im Betrieb des piezoelektrischen Bauelements lokale Spannungen durch die unterschiedlichen Dehnungen der piezoelektrischen Schichten 2, 3 senkrecht zum elektrischen Feld entstehen. Die lokalen Spannungen führen im Bereich der Kontaktgrenze 6 zur Bildung von Rissen. Die Risse verlaufen dabei im Wesentlichen parallel zu den Elektrodenschichten 4, 5.

Weiterhin weist der Stapel 1a eine weitere erste piezoelektrische Schicht 2' auf, die ebenfalls direkt benachbart zur zweiten piezoelektrischen Schicht 3 angeordnet ist und die mit der zweiten piezoelektrischen Schicht 3 eine weitere Kontaktgrenze 6' aufweist, an der sich ebenfalls gezielt Risse bilden können, die im Wesentlichen parallel zu den Elektrodenschichten 4, 5 verlaufen.

Die ersten piezoelektrischen Schichten 2, 2' und die zweite piezoelektrische Schicht 3 weisen in diesem Ausführungsbeispiel jeweils ein Keramikmaterial basierend auf Blei-Zirkonat-Titanat (PZT) auf. Die zweite piezoelektrische Schicht 3 weist eine Zusammensetzung mit einer anderen Konzentration des Bestandteils Titan auf als die ersten piezoelektrischen Schichten 2, 2', was zu den unterschiedlichen piezoelektrischen Ladungskonstanten d31 der ersten und zweiten Schichten 2, 2', 3 führt. Die Schichtdicken der piezoelektrischen Schichten 2, 2', 3 sind im gezeigten Ausführungsbeispiel gleich, können aber auch verschieden voneinander sein.

Zusätzlich oder alternativ können sich die ersten und zweiten piezoelektrischen Schichten 2, 2' 3 in diesem und den weiteren Ausführungsbeispielen hinsichtlich des jeweiligen Keramikmaterials, des Dotierstoffs, der Dotierstoffkonzentrationen oder der Partikelgrößen des jeweils verwendeten Ausgangsmaterials unterscheiden, um die unterschiedlichen piezoelektrischen Ladungskonstanten d31 der ersten piezoelektrischen Schichten 2, 2' und der zweiten piezoelektrischen Schicht 3 zu erzielen. Beispielsweise kann die erste piezoelektrische Schicht 2, 2' ein bleihaltiges Keramikmaterial, zum Beispiel PZT, aufweisen. Die zweite piezoelektrische Schicht 3 kann ein bleiloses Keramikmaterial aufweisen.

Zusätzlich oder alternativ können die ersten piezoelektrischen Schichten 2, 2' und die zweite piezoelektrische Schicht 3 dadurch unterschiedliche piezoelektrischen Ladungskonstanten d31 aufweisen, dass sie unterschiedliche Curie-Temperaturen aufweisen.

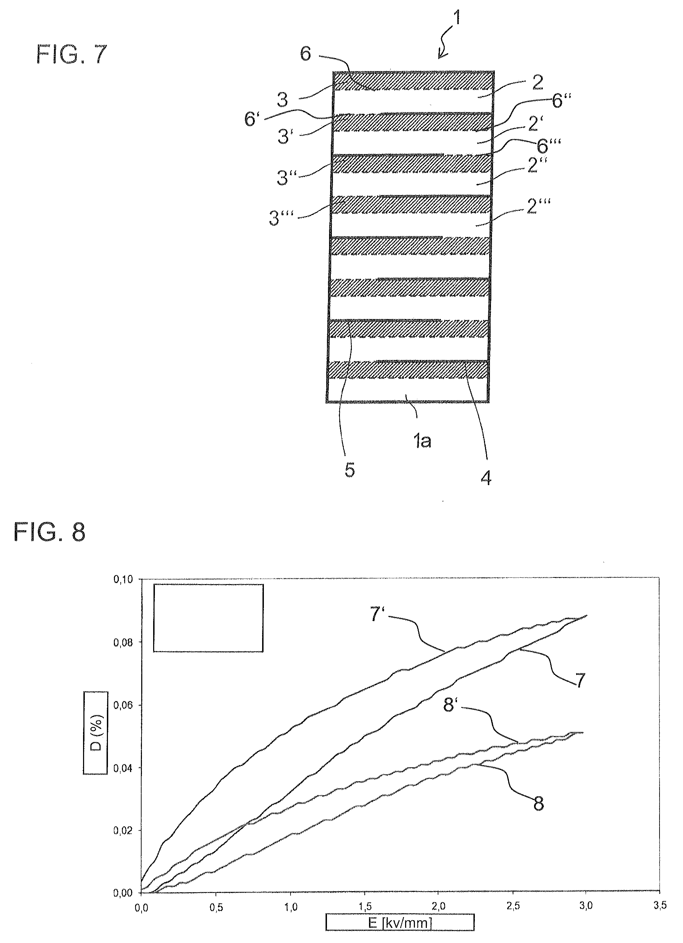

Ausführungsbeispiele für die Dehnung der piezoelektrischen Materialien, die Curie-Temperaturen und die piezoelektrischen Ladungskonstanten d31 entsprechender piezoelektrischer Materialien sind in Zusammenhang mit den Figuren 8 bis 10 beschrieben.

Figur 5 zeigt eine schematische Darstellung eines piezoelektrischen Bauelements gemäß einer weiteren Ausführungsform.

Im Vergleich zu dem Ausführungsbeispiel aus Figur 4 weist der Stapel 1a des piezoelektrischen Bauelements neben einer Mehrzahl an ersten piezoelektrischen Schichten 2, 2',2", 2"' auch eine Mehrzahl von zweiten piezoelektrischen Schichten 3, 3', 3", 3"' auf, wobei die ersten und zweiten piezoelektrischen Schichten abwechselnd übereinander angeordnet sind, so dass sich eine Mehrzahl an Kontaktgrenzen 6, 6', 6", 6"' ergibt, an denen sich gezielt Risse bilden können. Im gezeigten Ausführungsbeispiel weist der Stapel 1a gleich viele erste und zweite piezoelektrische Schichten auf, so dass 50% aller piezoelektrischen Schichten im Stapel 1a als zweite piezoelektrische Schichten 3 ausgebildet sind.

Auch in diesem Ausführungsbeispiel weist der Stapel 1a eine Abfolge von Schichten auf, die gebildet wird durch eine erste Elektrodenschicht 4 mit einer ersten Polarität bei einer an die Elektrodenschichten 4, 5 angelegten Spannung, eine erste piezoelektrische Schicht 2, eine zweite Elektrodenschicht 5 mit einer zweiten Polarität bei einer an die Elektrodenschichten 4, 5 angelegten Spannung, eine zweite piezoelektrische Schicht 3 und eine weitere erste Elektrodenschicht 4.

Figur 6 und Figur 7 zeigen eine schematische Darstellung eines piezoelektrischen Bauelements gemäß einer weiteren Ausführungsform.

In den Figuren 6 und 7 sind weitere Ausführungsbeispiele für piezoelektrische Bauelemente gezeigt, die sich von den Ausführungsbeispielen in den Figuren 4 und 5 dadurch unterscheiden, dass eine erste und eine zweite piezoelektrische Schicht 2, 3 direkt benachbart zueinander und insbesondere gemeinsam zwischen einer ersten Elektrodenschicht 4 und einer zu dieser benachbarten zweiten Elektrodenschicht 5 angeordnet sind.

Gemäß dem Ausführungsbeispiel in Figur 6 ist im Stapel 1a lediglich einmal eine erste und direkt benachbart dazu eine zweite piezoelektrische Schicht 2, 3 zwischen zwei benachbarten Elektrodenschichten 4, 5 angeordnet. Daneben umfasst der Stapel 1a eine Vielzahl von ersten piezoelektrischen Schichten 2 zwischen zwei benachbarten Elektrodenschichten 4, 5.

Gemäß dem Ausführungsbeispiel in Figur 7 sind zwischen allen benachbarten Elektrodenschichten 4, 5 eine erste und eine zweite piezoelektrische Schicht 2, 2', 2", 2"', 3, 3', 3", 3"' angeordnet. Zwischen zwei benachbarten Elektrodenschichten 4, 5 ergibt sich so jeweils eine Kontaktgrenze 6, 6', 6", 6"', an der sich gezielt Risse bilden können.

Alternativ zu den Ausführungsbeispielen der Figuren 6 und 7 können auch mehr als eine erste und eine zweite piezoelektrische Schicht zwischen zwei benachbarten Elektrodenschichten 4, 5 angeordnet sein. Im Übrigen gelten alle in Zusammenhang mit den Ausführungsbeispielen der Figuren 4 und 5 beschriebenen Merkmale für die in den Figuren 6 und 7 beschriebenen Ausführungsbeispiele.

In Figur 8 ist ein Graph mit Kurven 7, 7', 8 und 8' für die prozentuale Dehnung D zweier verschiedener, beispielhaft gezeigter piezoelektrischer Materialien senkrecht zum elektrischen Feld als Funktion der elektrischen Feldstärke E in kV/mm gezeigt. Aus den piezoelektrischen Materialien können erste und zweite piezoelektrische Schichten der vorher beschriebenen Ausführungsbeispiele hergestellt werden.

Das piezoelektrische Material, dessen Dehnung D senkrecht zum elektrischen Feld in den Kurven 7, 7' dargestellt ist, weist eine piezoelektrische Ladungskonstante d31 von 290 pC/N auf. Das piezoelektrische Material, dessen Dehnung D senkrecht zum elektrischen Feld in den Kurven 8, 8' gezeigt ist, weist eine piezoelektrische Ladungskonstante d31 von 170 pC/N auf. Die Kurven 7, 8 zeigen jeweils die Dehnung D des entsprechenden piezoelektrischen Materials beim Aufbau des elektrischen Feldes. Die Kurven 7', 8' zeigen jeweils die Dehnung D des entsprechenden piezoelektrischen Materials beim Herunterfahren des elektrischen Feldes. Demnach ist die Dehnung D senkrecht zum elektrischen Feld bei gegebener Feldstärke E bei beiden piezoelektrischen Materialen beim Herunterfahren des elektrischen Feldes größer, als beim Aufbau des elektrischen Feldes, so dass für das jeweilige piezoelektrische Material eine Hysteresekurve 7, 7' bzw. 8, 8' zu beobachten ist.

Bei beiden piezoelektrischen Materialien wächst die Dehnung D mit steigender elektrischer Feldstärke E an bis zu einer hier dargestellten maximalen Feldstärke E von ca. 3 kV/mm. In dem Material zu Kurve 7, 7', bei dem die piezoelektrische Ladungskonstante d31 größer ist als in dem Material zu Kurve 8, 8', wird bei einer maximalen elektrischen Feldstärke E von 3,0 kV/mm eine hohe Dehnung D bis zu 0,085% in der Richtung senkrecht zum elektrischen Feld erreicht. Das Material zu Kurve 8, 8' mit der kleineren piezoelektrischen Ladungskonstante d31 weist hingegen eine deutlich geringere Dehnung D von 0,045% bei der maximalen elektrischer Feldstärke E von 3 kV/mm auf. Der Unterschied in den piezoelektrischen Ladungskonstanten d31 und somit der Unterschied in der maximalen Dehnung D des jeweiligen piezoelektrischen Materials beträgt in diesem Ausführungsbeispiel folglich ungefähr einen Faktor 2.

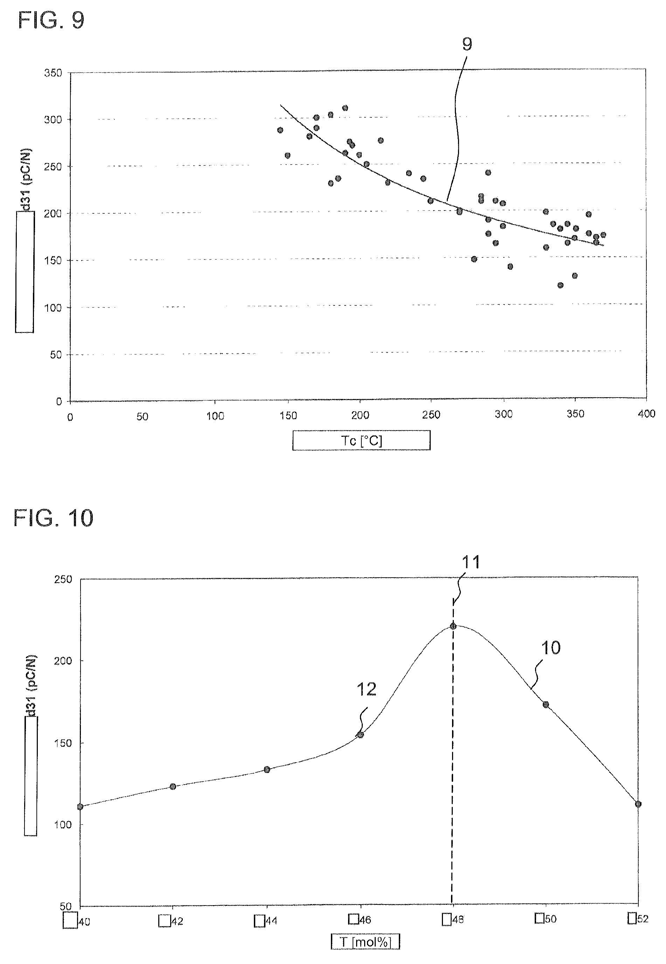

In Figur 9 ist ein Graph 9 dargestellt, der eine Abhängigkeit der piezoelektrischen Ladungskonstanten d31 in pC/N verschiedener piezoelektrischer Materialien auf Basis von PZT von der jeweiligen Curie-Temperatur T_{C} zeigt. Die Curie-Temperaturen T_{C} der piezoelektrischen Materialen liegen dabei zwischen ca. 150 °C und ca. 350 °C. Der Wert der Ladungskonstanten d31 sinkt mit zunehmender Curie-Temperatur T_{C} des jeweiligen Materials ab. Je höher also die Curie-Temperatur T_{C} eines piezoelektrischen Materials ist, desto kleiner ist die Dehnung des Materials in einem elektrischen Feld vorgegebener Stärke. Durch eine geeignete Wahl der Curie-Temperaturen T_{C} der piezoelektrischen Schichten kann somit eine unterschiedliche Dehnung der Schichten bei einem elektrischen Feld mit vorgegebener Stärke erreicht werden, was zur gezielten Rissbildung insbesondere an der Kontaktgrenze zwischen den piezoelektrischen Schichten sowie einem Verlauf der Risse im Wesentlichen parallel zu den Elektrodenschichten führt.

Aus Figur 9 wird ersichtlich, dass für piezoelektrische Materialien mit gleicher Curie-Temperatur T_{C} eine Streuung in den Werten für die piezoelektrische Ladungskonstante d31 auftritt, die bei 300 °C zwischen 150 pC/N und 240 pC/N liegt. Diese Streuung kann durch physikalische Effekte, wie beispielsweise Blockierung von Domänenumwandlungen durch Defekte im Keramikmaterial, verursacht werden.

In Figur 10 ist ein Graph 10 für die Abhängigkeit der piezoelektrischen Ladungskonstanten d31 vom Titangehalt T in einem piezoelektrischen Material auf Blei-Zirkonat-Titanat Basis gemäß einem Ausführungsbeispiel dargestellt. Mit dem Bezugszeichen 11 ist eine morphotrope Phasengrenze des piezoelektrischen Materials angedeutet, welche bei etwa 48 mol% der Titankonzentration liegt. Mit ansteigendem Titangehalt T ist nach dem Überschreiten der morphotropen Phasengrenze ein Absinken der piezoelektrischen Ladungskonstante d31 ersichtlich.

Für die erste piezoelektrische Schicht und für die zweite piezoelektrische Schicht können Keramikmaterialen wie beispielsweise PZT mit der gleichen Zusammensetzung gewählt werden, welche auf Grund des jeweiligen Titangehalts T im Keramikmaterial unterschiedliche piezoelektrischen Ladungskonstanten d31 auf verschiedenen Seiten der morphotropen Phasengrenze 11 aufweisen. So kann beispielsweise für die erste piezoelektrische Schicht ein Material mit einem Titangehalt T von weniger als etwa 48 mol% vorzugsweise 46 mol% (angedeutet durch Punkt 12 in Figur 10), und für die zweite piezoelektrische Schicht ein Material mit einem Titangehalt T um etwa 48 mol% (angedeutet durch einen Punkt in der Nähe der morphotropen Phasengrenze 11 in Figur 10), ausgewählt werden, so dass die erste piezoelektrische Ladungskonstante d31 kleiner ist als die zweite piezoelektrische Ladungskonstante d31.

Die vorab explizit erwähnten Keramikmaterialen sind rein beispielhaft genannt und sind nicht als Beschränkung der beschriebenen Ausführungsformen zu verstehen. Vielmehr können die vorab beschriebenen Ausführungsformen und Ausführungsbeispiele auch andere piezoelektrische Keramikmaterialen als die genannten Keramikmaterialen aufweisen.

### Bezugszeichenliste

- 1: Piezoelektrisches Bauelement
- 1a: Stapel
- 2, 2', 2", 2"': Erste piezoelektrische Schicht
- 3, 3', 3", 3"': Zweite piezoelektrische Schicht
- 4: Erste Elektrodenschicht
- 5: Zweite Elektrodenschicht
- 6, 6': Kontaktgrenze
- 7, 7': Dehnung
- 8, 8': Dehnung
- 9: Piezoelektrische Ladungskonstante
- 10: Piezoelektrische Ladungskonstante
- 11: Morphotrope Phasengrenze
- 12: Punkt
- 91: Stapel
- 92: Innenelektrode
- 93: Innenelektrode
- 94: Metallisierung
- 95: Metallisierung
- 96: Aktiver Bereich
- 97: Inaktiver Bereich
- 98: Riss
- 99: Riss
- 100: Piezoelektrische Schicht
- 101: Piezoelektrisches Material
- 102: Piezoelektrisches Material
- 103: Verformung des Materials senkrecht zu den Feldlinien des elektrischen Feldes
- 104: Verformung des Materials parallel zu den Feldlinien des elektrischen Feldes
- 105: Zugspannung
- 106: Druckspannung

## Patentansprüche

1. Piezoelektrisches Bauelement (1) aufweisend einen Stapel (1a) aus übereinander angeordneten piezoelektrischen Schichten (2, 2', 2", 2"', 3, 3', 3", 3"') und dazwischen angeordneten Elektrodenschichten (4, 5), bei dem der Stapel (1a) zumindest eine erste piezoelektrische Schicht (2) mit einer ersten piezoelektrischen Ladungskonstanten und direkt dazu benachbart mindestens eine zweite piezoelektrische Schicht (3) mit einer zweiten piezoelektrischen Ladungskonstanten aufweist, wobei die piezoelektrische Ladungskonstante eine Ausdehnung der piezoelektrische Schicht (2, 3) senkrecht zu einem elektrischen Feld bei einer an die Elektrodenschichten (4, 5) angelegten Spannung beschreibt, und wobei die erste piezoelektrische Ladungskonstante verschieden von der zweiten piezoelektrischen Ladungskonstanten ist,
bei dem die eine der beiden piezoelektrischen Ladungskonstanten um einen Faktor 1,2 bis 3,0 größer ist als die andere der beiden piezoelektrischen Ladungskonstanten und bei dem eine Kontaktgrenze (6) zwischen den beiden Schichten (2, 3) ausgebildet ist, wobei beim Anlegen einer elektrischen Spannung aufgrund der unterschiedlichen Ladungskonstanten eine unterschiedliche Dehnung der Schichten (2, 3) auftritt, um gezielt Risse an der Kontaktgrenze (6) zu bilden und entlang der Kontaktgrenze (6) zu führen.

2. Piezoelektrisches Bauelement (1) nach Anspruch 1,
bei dem die gebildeten Risse im Wesentlichen parallel zu den Elektrodenschichten (4, 5) verlaufen.

3. Piezoelektrisches Bauelement (1) nach einem der Ansprüche 1 oder 2,
bei dem die erste piezoelektrische Schicht (2) und die zweite piezoelektrische Schicht (3) unterschiedliche Curie-Temperaturen aufweisen.

4. Piezoelektrisches Bauelement (1) nach Anspruch 3, bei dem der Unterschied zwischen den Curie-Temperaturen der ersten piezoelektrischen Schicht (2) und der zweiten piezoelektrischen Schicht (3) 20°C bis 200°C beträgt.

5. Piezoelektrisches Bauelement (1) nach einem der Ansprüche 1 bis 4,
bei dem sich die erste piezoelektrische Schicht (2) und die zweite piezoelektrische Schicht (3) in mindestens einer der folgenden Eigenschaften unterscheiden:
Keramikmaterial, Dotierstoff, Dotierstoffkonzentrationen, Partikelgrößen des Ausgangsmaterials, Schichtdicke.

6. Piezoelektrisches Bauelement (1) nach Anspruch 5,
bei dem die erste und die zweite piezoelektrische Schicht (2, 3) jeweils ein Keramikmaterial aufweist welches aus mehreren Elementen gebildet ist, wobei die Elemente jeweils in einer bestimmten Konzentration vorliegen und wobei sich die erste und die zweite piezoelektrische Schicht (2, 3) in der Konzentration zumindest eines der Elemente des Keramikmaterials voneinander unterscheiden.

7. Piezoelektrisches Bauelement (1) nach Anspruch 6,
bei dem die erste und die zweite piezoelektrische Schicht (2, 3) jeweils aus einem Keramikmaterial mit den gleichen Elementen gebildet ist, wobei das Keramikmaterial in Abhängigkeit der Konzentration zumindest eines der Elemente im Keramikmaterial zwei unterschiedliche Strukturen aufweist und wobei die Konzentrationen des zumindest einen Elements des Keramikmaterials in der ersten und zweiten piezoelektrischen Schicht (2, 3) jeweils derart gewählt sind, dass die erste piezoelektrische Schicht (2) das Keramikmaterial mit der ersten Struktur und die zweite piezoelektrische Schicht (3) das Keramikmaterial mit der zweiten Struktur aufweist.

8. Piezoelektrisches Bauelement (1) nach einem der Ansprüche 5 bis 7,
bei dem die erste und die zweite piezoelektrische Schicht (2, 3) Keramikmaterialen hergestellt aus Ausgangspulvern mit unterschiedlichen Partikelgrößen aufweisen, wobei die Partikelgröße der Ausgangspulver größer oder gleich 0,3 µm und kleiner oder gleich 2,0 µm beträgt und
wobei der Unterschied in den Partikelgrößen der Ausgangspulver größer oder gleich 0,1 µm und kleiner oder gleich 1,5 µm beträgt.

9. Piezoelektrisches Bauelement (1) nach einem der Ansprüche 5 bis 8,
bei dem die erste piezoelektrische Schicht (2) eine erste Schichtdicke aufweist und die zweite piezoelektrische Schicht (3) eine zweite Schichtdicke aufweist, wobei die erste und die zweite Schichtdicke voneinander verschieden sind und wobei das Verhältnis der ersten und zweiten Schichtdicke größer oder gleich 1,1 und kleiner oder gleich 3,0 beträgt.

10. Piezoelektrisches Bauelement (1) nach einem der vorigen Ansprüche,
bei dem der Stapel (1a) eine Abfolge von direkt übereinander angeordneten Schichten aufweist, wobei die Abfolge gebildet ist aus einer ersten Elektrodenschicht (4) mit einer ersten Polarität bei einer an die Elektrodenschichten (4, 5) angelegten Spannung, der ersten piezoelektrischen Schicht (2), einer zweiten Elektrodenschicht (5) mit einer zweiten Polarität bei einer an die Elektrodenschichten (4, 5) angelegten Spannung, der zweiten piezoelektrischen Schicht (3) und einer weiteren ersten Elektrodenschicht (4).

11. Piezoelektrisches Bauelement (1) nach einem der Ansprüche 1 bis 9,
bei dem der Stapel (1a) eine Abfolge von direkt übereinander angeordneten Schichten aufweist, wobei die Abfolge gebildet ist aus einer ersten Elektrodenschicht (4) mit einer ersten Polarität bei einer an die Elektrodenschichten (4, 5) angelegten Spannung, der ersten piezoelektrischen Schicht (2), der zweiten piezoelektrischen Schicht (3) und einer zur ersten Elektrodenschicht benachbarten zweiten Elektrodenschicht (5) mit einer zweiten Polarität bei einer an die Elektrodenschichten (4, 5) angelegten Spannung.

12. Piezoelektrisches Bauelement (1) nach einem der vorigen Ansprüche,
bei dem die Anzahl der ersten piezoelektrischen Schichten (2) verschieden ist von der Anzahl der zweiten piezoelektrischen Schichten (3).

13. Piezoelektrisches Bauelement (1) nach einem der Ansprüche 1 bis 11,
bei dem der Stapel gleich viele erste und zweite piezoelektrische Schichten (2, 3) aufweist.

## Claims

1. Piezoelectric component (1) comprising a stack (1a) of piezoelectric layers (2, 2', 2", 2"', 3, 3', 3", 3"') arranged on one another and electrode layers (4, 5) arranged between them, wherein the stack (1a) comprises at least one first piezoelectric layer (2) having a first piezoelectric charge constant and, directly neighboring the latter, at least one second piezoelectric layer (3) having a second piezoelectric charge constant, the piezoelectric charge constant describing an expansion of the piezoelectric layer (2, 3) perpendicular to an electric field when a voltage is applied to the electrode layers (4, 5), and the first piezoelectric charge constant being different to the second piezoelectric charge constant,
wherein one of the two piezoelectric charge constants is greater by a factor of from 1.2 to 3.0 than the other of the two piezoelectric charge constants, and wherein a contact interface (6) is formed between the two layers (2, 3), wherein, when an electrical voltage is applied, a different expansion of the layers (2,3) arises on account of the different charge constants, in order to form cracks at the contact interface (6) and guide them along the contact interface (6) in a controlled way.

2. Piezoelectric component (1) according to Claim 1, wherein the formed cracks extend essentially parallel to the electrode layers (4,5).

3. Piezoelectric component (1) according to one of Claims 1 and 2,
wherein the first piezoelectric layer (2) and the second piezoelectric layer (3) have different Curie temperatures.

4. Piezoelectric component (1) according to Claim 3,
wherein the difference between the Curie temperatures of the first piezoelectric layer (2) and the second piezoelectric layer (3) is from 20°C to 200°C.

5. Piezoelectric component (1) according to one of Claims 1 to 4,
wherein the first piezoelectric layer (2) and the second piezoelectric layer (3) differ in terms of at least one of the following properties:
ceramic material, dopant, dopant concentrations, particle sizes of the starting material, layer thickness.

6. Piezoelectric component (1) according to Claim 5, wherein the first and second piezoelectric layers (2, 3) respectively comprise a ceramic material which is formed from a plurality of elements, the elements respectively being present in a particular concentration and the first and second piezoelectric layers (2, 3) differing from one another in terms of the concentration of at least one of the elements of the ceramic material.

7. Piezoelectric component (1) according to Claim 6, wherein the first and second piezoelectric layers (2, 3) are respectively formed from a ceramic material comprising the same elements, the ceramic material having two different structures as a function of the concentration of at least one of the elements in the ceramic material and the concentrations of the at least one element of the ceramic material in the first and second piezoelectric layers (2, 3) respectively being selected so that the first piezoelectric layer (2) comprises the ceramic material with the first structure and the second piezoelectric layer (3) comprises the ceramic material with the second structure.

8. Piezoelectric component (1) according to one of Claims 5 to 7,
wherein the first and second piezoelectric layers (2, 3) comprise ceramic materials produced from starting powders having different particle sizes, the particle size of the starting powders being greater than or equal to 0.3 µm and less than or equal to 2.0 µm and the difference between the particle sizes of the starting powders being greater than or equal to 0.1 µm and less than or equal to 1.5 µm.

9. Piezoelectric component (1) according to one of Claims 5 to 8,
wherein the first piezoelectric layer (2) has a first layer thickness and the second piezoelectric layer (3) has a second layer thickness, the first and second layer thicknesses being different to one another and the ratio of the first and second layer thicknesses being greater than or equal to 1.1 and less than or equal to 3.0.

10. Piezoelectric component (1) according to one of the preceding claims,
wherein the stack (1a) comprises a sequence of layers arranged directly on one another, the sequence being formed from a first electrode layer (4) having a first polarity when a voltage is applied to the electrode layers (4, 5), the first piezoelectric layer (2), a second electrode layer (5) having a second polarity when a voltage is applied to the electrode layers (4, 5), the second piezoelectric layer (3) and a further first electrode layer (4).

11. Piezoelectric component (1) according to one of Claims 1 to 9,
wherein the stack (1a) comprises a sequence of layers arranged directly on one another, the sequence being formed from a first electrode layer (4) having a first polarity when a voltage is applied to the electrode layers (4, 5), the first piezoelectric layer (2), the second piezoelectric layer (3) and a second electrode layer (5), neighboring the first electrode layer, having a second polarity when a voltage is applied to the electrode layers (4, 5).

12. Piezoelectric component (1) according to one of the preceding claims,
wherein the number of first piezoelectric layers (2) is different to the number of second piezoelectric layers (3).

13. Piezoelectric component (1) according to one of Claims 1 to 11,
wherein the stack comprises an equal number of first and second piezoelectric layers (2, 3).

## Revendications

1. Composant piézoélectrique (1) comportant une pile (1a) de couches piézoélectriques (2, 2', 2", 2"', 3, 3', 3", 3"') superposées et des couches d'électrodes (4, 5) intercalées entre ces dernières, sur lequel la pile (1a) comporte au moins une première couche piézoélectrique (2) avec une première constante de charge piézoélectrique et au voisinage direct, au moins une deuxième couche piézoélectrique (3) avec une deuxième constante de charge piézoélectrique, la constante de charge piézoélectrique décrivant une expansion de la couche piézoélectrique (2, 3) à la perpendiculaire d'un champ électrique pour une tension appliquée sur les couches d'électrodes (4, 5) et la première constante de charge piézoélectrique étant différente de la deuxième constante de charge piézoélectrique,
sur lequel l'une des deux constantes de charge piézoélectriques est supérieure d'un coefficient de 1,2 à 3,0 à l'autre des deux constantes de charge piézoélectriques et sur lequel une limite de contact (6) est conçue entre les deux couches (2, 3), lors de l'application d'une tension électrique, en raison des différentes constantes de charge se produisant une expansion différente des couches (2, 3) pour créer de manière ciblée des fissures sur la limite de contact (6) et les conduire le long de la limite de contact (6).

2. Composant piézoélectrique (1) selon la revendication 1, sur lequel les fissures créées s'écoulent sensiblement à la parallèle des couches d'électrodes (4, 5).

3. Composant piézoélectrique (1) selon l'une quelconque des revendications 1 ou 2,
sur lequel la première couche piézoélectrique (2) et la deuxième couche piézoélectrique (3) présentent différentes températures de Curie.

4. Composant piézoélectrique (1) selon la revendication 3, sur lequel la différence entre les températures de Curie de la première couche piézoélectrique (2) et de la deuxième couche piézoélectrique (3) est de 20°C à 200°C.

5. Composant piézoélectrique (1) selon l'une quelconque des revendications 1 à 4,
sur lequel la première couche piézoélectrique (2) et la deuxième couche piézoélectrique (3) se différencient par au moins l'une des propriétés suivantes :
matière céramique, substance de dopage, concentrations en substance de dopage, tailles des particules de la matière de départ, épaisseur de couche.

6. Composant piézoélectrique (1) selon la revendication 5,
sur lequel la première et la deuxième couche piézoélectrique (2, 3) comportent chacune une matière céramique, laquelle est formée par plusieurs éléments, les éléments se présentant chacun dans une concentration déterminée et la première et la deuxième couche piézoélectrique (2, 3) se différenciant l'une de l'autre dans la concentration d'au moins l'un des éléments de la matière céramique.

7. Composant piézoélectrique (1) selon la revendication 6,
sur lequel la première et la deuxième couche piézoélectrique (2, 3) sont formées chacune en une matière céramique avec les mêmes éléments, en fonction de la concentration d'au moins l'un des éléments dans la matière céramique, la matière céramique présentant deux structures différentes et les concentrations de l'au moins un élément de la matière céramique dans la première et la deuxième couche piézoélectrique (2, 3) étant choisies chacune de sorte que la première couche piézoélectrique (2) comporte la matière céramique avec la première structure et la deuxième couche piézoélectrique (3) comporte la matière céramique avec la deuxième structure.

8. Composant piézoélectrique (1) selon l'une quelconque des revendications 5 à 7,
sur lequel la première et la deuxième couche piézoélectrique (2, 3) comportent des matières céramiques fabriquées à partir de poudres de départ avec différentes tailles de particules, la taille de particules de la poudre de départ étant supérieure ou égale à 0,3 µm et inférieure ou égale à 2,0 µm et
la différence dans les tailles de particules des poudres de départ étant supérieure ou égale à 0,1 µm et inférieure ou égale à 1,5 µm.

9. Composant piézoélectrique (1) selon l'une quelconque des revendications 5 à 8,
sur lequel la première couche piézoélectrique (2) présente une première épaisseur de couche et la deuxième couche piézoélectrique (3) présente une deuxième épaisseur de couche, la première et la deuxième épaisseur de couche étant différentes l'une de l'autre et le rapport entre la première et la deuxième épaisseur de couche étant supérieur ou égal à 1, 1 et inférieur ou égal à 3,0.

10. Composant piézoélectrique (1) selon l'une quelconque des revendications précédentes,
sur lequel la pile (1a) comporte une succession de couches directement superposées, la succession étant formée par une première couche d'électrodes (4) avec une première polarité lorsqu'une tension est appliquée aux couches d'électrodes (4, 5) de la première couche piézoélectrique (2), une deuxième couche d'électrodes (5) avec une deuxième polarité lorsqu'une tension est appliquée aux couches d'électrodes (4, 5) de la deuxième couche piézoélectrique (3) et une première couche d'électrodes (4) supplémentaire.

11. Composant piézoélectrique (1) selon l'une quelconque des revendications 1 à 9,
sur lequel la pile (1a) comporte une succession de couches directement superposées, la succession étant formée par une première couche d'électrodes (4) avec une première polarité lorsqu'une tension est appliquée aux couches d'électrodes (4, 5) de la première couche piézoélectrique (2), de la deuxième couche piézoélectrique (3) et une deuxième couche d'électrodes (5) voisine de la première couche d'électrodes, avec une deuxième polarité lorsqu'une tension est appliquée sur les couches d'électrodes (4, 5).

12. Composant piézoélectrique (1) selon l'une quelconque des revendications précédentes,
sur lequel le nombre des premières couches piézoélectriques (2) est différent du nombre des deuxièmes couches piézoélectriques (3).

13. Composant piézoélectrique (1) selon l'une quelconque des revendications 1 à 11,
sur lequel la pile comporte autant de premières que de deuxièmes couches piézoélectriques (2, 3).
